# EUROPÄISCHE PATENTSCHRIFT

(11) **EP 3 528 604 B1**
(45) Veröffentlichungstag und Bekanntmachung des Hinweises auf die Patenterteilung: **19.10.2022**
(21) Anmeldenummer: 19157177.7
(22) Anmeldetag: 14.02.2019
(51) Int. Cl.: H05K 5/02

(54) **VORRICHTUNG MIT EINEM DRUCKAUSGLEICHSELEMENT SOWIE VERFAHREN ZUR HERSTELLUNG EINER KOMPONENTE DER VORRICHTUNG**
DEVICE WITH A PRESSURE EQUALIZING ELEMENT AND METHOD FOR PRODUCING A COMPONENT OF THE DEVICE
DISPOSITIF DOTÉ D'UN ÉLÉMENT DE COMPENSATION DE PRESSION AINSI QUE PROCÉDÉ DE FABRICATION D'UN COMPOSANT DU DISPOSITIF

(30) Priorität: 20.02.2018 DE 102018103747
(43) Veröffentlichungstag der Anmeldung: 21.08.2019
(73) Patentinhaber: VOLKSWAGEN AKTIENGESELLSCHAFT, 38440 Wolfsburg (DE)
(72) Erfinder: Weber, Dennis, 38159 Vechelde GT Wahle (DE); Kujat, Sergej, 38304 Wolfenbüttel (DE); Bachmann, Stephan, 38855 Wernigerode (DE)
(74) Vertreter: Scheffler, Jörg

(56) Entgegenhaltungen:
- WO-A1-2006/056504
- WO-A1-2014/073096
- DE-A1-102010 042 254
- DE-A1-102013 100 257
- DE-T5-112013 004 771

## Beschreibung

Die Erfindung betrifft eine Vorrichtung mit einem Druckausgleichselement, wobei das Druckausgleichselement zwischen zwei Druckräumen einen Druckausgleich ermöglichend angeordnet ist. Hierbei ist das Druckausgleichselement zumindest gen eines ersten Druckraumes der Druckräume gerichtet und mit diesem ersten Druckraum über einen Ausgleichskanal wirkverbunden. Weiterhin betrifft die Erfindung ein Verfahren zur Herstellung einer Komponente der Vorrichtung.

In vielen Anwendungsgebieten, insbesondere auch im Kraftfahrzeugbereich, ist es notwendig, die Beständigkeit elektrischer und/oder elektronischer Bauteile und/oder Baugruppen gegenüber Umwelteinflüssen sicherzustellen und diese Beständigkeit zu testen. Gerade im Kraftfahrzeugbau ist hierbei die Beständigkeit gegenüber dem Eindringen von Fremdkörpern in fester oder flüssiger Form, wie beispielsweise Wasser, von Bedeutung.

Die Eignung der Bauteile und/oder Baugruppen für bestimmte Umweltbedingungen ist hierbei in unterschiedliche IP-Schutzarten gegliedert. Dabei sind je nach Schutzart Prüfungsverfahren definiert, welche die Umweltbedingungen nachempfinden.

Nach ISO 20653 ist beispielsweise die Schutzart IPX9K definiert, welche den Schutz gegen das Eindringen von Wasser bei Hochdruck- respektive Dampfstrahlreinigung beinhaltet.

Zudem ist z. B. bei in einem Kraftfahrzeug angeordneten Pumpen, welche eine Elektronikkomponente oder Elektronikkomponenten beinhalten, zu beachten, dass aufgrund eines Druckgefälles die Gefahr einer Kondenswasserbildung innerhalb des Bereiches der Elektronikkomponenten vermieden werden muss, um eine Korrosion und dadurch verursachte Defekte zu vermeiden. Hierfür werden regelmäßig Druckausgleichselemente verwendet, welche wasserdampfdurchlässig ausgeprägt sind.

Solche wasserdampfdurchlässigen Druckausgleichselemente liegen oftmals in Form von Membranen, beispielsweise in Form von PTFE-Membranen vor.

Die Verwendung von Membranen als Druckausgleichelemente zeigt beispielshaft die DE 1 201 686 A. In der Druckschrift ist hierbei die Abgrenzung eines wassergefüllten Druckraumes einer Schraubenpumpe gegenüber einem schmiermittelbehafteten Lagerbereich einer Antriebswelle der Schraubenpumpe beschrieben. Die Abgrenzung erfolgt mittels zweier parallel zueinander angeordneter Membranen, welche sich quer zur Axialrichtung der Antriebswelle erstrecken. Somit ist den Membranen neben der Druckausgleichsfunktion gegenüber dem Druckraum zudem eine Dichtfunktion zugeordnet. Zwischen den Membranen sind in radialer Richtung zudem Bohrungen vorgesehen, um ein gegebenenfalls entstehendes Schmiermittel-WasserGemisch nach außen abführen zu können.

Besteht die Notwendigkeit, dass ein Bauteil oder eine Baugruppe wie eine Pumpe eine vorstehend beschriebene Schutzart aufweist, insbesondere die Schutzart IPX9K, und zugleich ein Druckausgleich mit der Umgebung über ein Druckausgleichselement vonnöten ist, ist es regelmäßig unumgänglich, ein solch als Membran ausgeführtes Druckausgleichselement gegenüber auftretenden, mechanischen Umgebungsbedingungen abzuschirmen. Dies ist dadurch bedingt, dass zum Zweck des Druckausgleiches die Membran mit der Umgebung in Kontakt stehen, jedoch gegen mechanische Einwirkungen von außen, wie im Falle der Schutzart IPX9K gegenüber einem Wasserhochdruckstrahl oder einem Wasserdampfstrahl, geschützt sein muss. Wäre dies nicht der Fall, käme es aufgrund einer äußerst geringen mechanischen Belastbarkeit unweigerlich zu einer Zerstörung der Membran.

Eine gegenüber äußeren mechanischen Einflüssen geschirmte Anordnung einer PTFE-Membran offenbart die DE 44 44 643 A1. Hierbei dient die PTFE-Membran dem Druckausgleich zwischen dem Inneren eines Elektromotors und der äußeren Umgebung. Die Druckschrift beinhaltet hierbei verschiedene Ausführungsformen, welche sich im Wesentlichen durch die Ausgestaltung der Anordnung der Membran in einem aus Kunststoff hergestellten, stirnseitigen Motorschild des Elektromotors und der damit verbundenen Ausgestaltung des das Innere des Elektromotors gegen die Umgebung sowie ein Pumpengehäuse abgrenzenden Motorschildes an sich unterscheiden. Die je nach Ausführungsform geklemmte, geklebte oder während des Herstellungsprozesses des Motorschildes umspritzte PTFE-Membran steht bei einer jeden der Ausführungsformen über einen Kanal oder ein Kanalsystem mit der Umgebung in einer den Druckausgleich ermöglichenden Verbindung. In einer der Ausführungsformen ist die Membran in einer zusätzlichen Kapsel aufgenommen, welche ihrerseits mittels an der Kapsel ausgeformten Rastnasen in dem Motorschild befestigt wird. Hierbei sind alle aufgeführten Ausführungsformen mit einem überaus hohen Konstruktions- und Fertigungsaufwand verbunden, was zudem eine Kostenintensivierung mit sich bringt.

Durch die WO 2014 / 073 096 A1 wird zudem ein Gehäuse für elektronische Komponenten beschrieben. Hierbei weist das Gehäuse eine Schutzausformung für eine Druckausgleichsmembran auf, wobei in der Schutzausformung Belüftungslöcher ausgeformt sind, über welche die Druckausgleichsmembran mit der Umgebung in Kontakt steht.

Auch der gattungsbildenden DE 10 2010 042 254 A1, der DE 11 2013 004 771 T5 oder der DE 10 2013 100 257 A1 sind jeweils Gehäuse für eine elektronische Schaltung mit einer Druckausgleichsmembran zur Verhinderung der Kondenswasserbildung zu entnehmen. Diese jeweilige Druckausgleichsmembran ist dabei über zwei in einem Gehäusefortsatz respektive Gehäuseabschnitt ausgebildete Entlüftungskanäle mit der Umgebung verbunden und ermöglicht so den Druckausgleich mit dem Gehäuseinneren.

In einer einer solchen Kapsel vergleichbar ausgestalteten Art sind sogenannte Snap-In- oder auch Einsteck-Druckausgleichselemente bekannt, welche insbesondere bei Umwälzpumpen Anwendung finden und entsprechend ebenfalls eine PTFE-Membran zum Zwecke des Druckausgleiches beinhalten. Die gekapselte Anordnung der PTFE-Membran bietet hierbei einen Schutz vor mechanischen Einflüssen, wie sie beispielsweise bei einem Test nach IPX9K auftreten. Nachteilig ist jedoch, dass diese Einsteck-Druckausgleichselemente mit hohen Kosten verbunden sind und die Konstruktion auf diese Einsteck-Druckausgleichselemente abgestimmt werden muss.

Vor diesem Hintergrund liegt der Erfindung die Aufgabe zugrunde, die Vorrichtung der eingangs genannten Art derart auszuführen, dass eine einfache, kostengünstige und mit einem geringen Fertigungsaufwand verbundene Möglichkeit geschaffen wird, einen Druckausgleich über ein Druckausgleichselement bei gleichzeitig gegebenem Schutz gegen äußere mechanische Einflüsse auf das Druckausgleichselement zu erreichen. Weiterhin besteht die Aufgabe darin, ein Verfahren zur Verfügung zu stellen, mittels welchem Teile der Vorrichtung hergestellt werden.

Die erstgenannte Aufgabe wird gelöst mit einer Vorrichtung gemäß den Merkmalen des Patentanspruches 1. Die Unteransprüche betreffen besonders zweckmäßige Weiterbildungen der Erfindung.

Erfindungsgemäß ist also eine Vorrichtung mit einem Druckausgleichselement vorgesehen, wobei das Druckausgleichselement zwischen zwei Druckräumen einen Druckausgleich ermöglichend angeordnet ist. Hierbei ist das Druckausgleichselement weiterhin zumindest gen eines ersten Druckraumes der Druckräume gerichtet und mit diesem ersten Druckraum über einen Ausgleichskanal wirkverbunden. Überdies ist der Ausgleichskanal zumindest teilweise in einer Abschirmungsstruktur ausgebildet, wobei diese Abschirmungsstruktur von einer eine Grenzfläche mit dem ersten Druckraum bildenden Oberfläche der Vorrichtung in Richtung des ersten Druckraumes ausgeformt ist. Denkbar ist, dass die Druckräume beliebige Druckräume sind, jedoch wäre der erste Druckraum in bevorzugter Weise z. B. das Innere oder zumindest ein Teil des Inneren der Vorrichtung. Der zweite Druckraum wiederum sollte die an die Vorrichtung angrenzende Umgebung sein, welche unter Atmosphärendruck steht. Die Abschirmstruktur, welche als eine Erhebung gegenüber der Oberfläche ausgestaltet wäre, kann einen im Wesentlichen rechteckigen oder gar quadratischen Querschnitt aufweisen. Ein kreisförmiger oder elliptischer Querschnitt sind jedoch ebenso denkbar, sodass beispielsweise eine zylindrische Gestaltung der Abschirmstruktur vorliegt. Das Druckausgleichselement wäre zudem in einer bevorzugten Ausgestaltung eine Druckausgleichsmembran, insbesondere eine PTFE-Membran. Die Ausformung der Abschirmstruktur an der die Grenzfläche bildenden Oberfläche der Vorrichtung hätte insbesondere den Vorteil, dass sich diese kostengünstig herstellen ließe und zugleich das Druckausgleichselement vor äußeren Einflüssen, wie den mechanischen Einflüssen eines Hochdruckwasser- oder auch Hochdruckdampfstrahles, geschützt wäre. Trotz des gegebenen Schutzes vor den äußeren Einflüssen wäre über den in der Abschirmstruktur zumindest teilweise ausgebildeten Ausgleichskanal ein Druckausgleich zwischen erstem und zweitem Druckraum gewinnbringend gegeben.

Erfindungsgemäß liegt der Durchmesser des ersten Kanalabschnittes zudem in einem Bereich von 2 Millimeter bis 3 Millimeter und der Durchmesser des zweiten Kanalabschnittes in einem Bereich von 1,5 Millimeter bis 2,5 Millimeter. Eine weiterhin bedeutungsvolle Ausgestaltung der Erfindung liegt darin begründet, dass der Durchmesser des ersten Kanalabschnittes 2,5 Millimeter und der Durchmesser des zweiten Kanalabschnittes 2 Millimeter betragen. Die Ausgestaltung von erstem und zweitem Kanalabschnitt in dieser Weise bietet den Vorteil, dass sich in Verbindung mit der Ausgestaltung der Abschirmstruktur ein Abschattungseffekt gegenüber äußeren mechanischen Einflüssen, wie einem gerichteten Hochdruckwasser- oder auch Hochdruckdampfstrahl, generieren lässt, wodurch sich einerseits der Schutz des Druckausgleichselementes vor diesen äußeren mechanischen Einflüssen steigern und andererseits das Eindringen von Flüssigkeit in den Ausgleichskanal minimieren oder gar verhindern lassen.

In einer überaus vorteilhaften Weiterbildung der Erfindung ist die Oberfläche Teil einer Mantelfläche einer den zweiten Druckraum zumindest teilweise gegenüber dem ersten Druckraum abgrenzenden Komponente der Vorrichtung. Denkbar ist hierbei, dass die Komponente aus einem Metall besteht und z. B. mittels eines Gießprozesses hergestellt wird, was eine gewinnbringend einfache und schnelle Herstellungsmethode darstellt.

Zudem ist als überaus vorteilhaft zu betrachten, wenn in der Komponente ein Sitz für das Druckausgleichelement ausgeformt ist, wobei dieser Sitz bevorzugt der Abschirmstruktur gegenüberliegend ausgeformt sein sollte. In einen solchen Sitz könnte das Druckausgleichselement, beispielsweise eine Druckausgleichsmembran, eingebracht und befestigt werden. Es ist hierbei denkbar, dass das Druckausgleichselement in dem Sitz kraft- und/oder formschlüssig, wie mittels Klemmens, befestigt wird. Bevorzugt wäre jedoch eine stoffschlüssige Verbindung beispielsweise durch ein Einkleben des Druckausgleichselementes. Darüber hinaus wäre zudem ein Reibschweißvorgang zur stoffschlüssigen Verbindung mit dem Sitz möglich. Weiterhin ist die Erfindung mit Vorteil behaftet, wenn der in der Komponente ausgeformte Sitz für das Druckausgleichselement eine dem Druckausgleichselement zugewandte Kontaktfläche aufweist, deren gemittelte Rautiefe R_{z} kleiner oder gleich 16 Mikrometer beträgt, was insbesondere bei einer stoffschlüssigen Verbindung des Druckausgleichselementes mit der Komponente, hierbei dem Sitz der Komponente, z. B. mittels Klebens oder Reibschweißens zu einer verbesserten Verbindung und ferner zu einer gesteigerten Dichtheit gegenüber dem Eindringen von Feststoffpartikeln, wie Staub und Flüssigkeiten wie Wasser, führen kann.

Eine Ausführungsform der Erfindung ist weiterhin als besonders erfolgversprechend zu betrachten, wenn ein erster Kanalabschnitt des Ausgleichskanales durch wenigstens eine zumindest teilweise in der Abschirmungsstruktur ausgeformte Ausnehmung ausgebildet ist, wodurch der erste Kanalabschnitt des Ausgleichskanales in einer fertigungstechnisch einfachen Weise z. B. bereits bei der Herstellung der Komponente der Vorrichtung mittels eines Gießprozesses in die Komponente eingebracht werden könnte und nicht nachträglich mittels weiterer Fertigungs- oder Bearbeitungsprozesse in die Komponente eingebracht werden müsste. Dies verringert den fertigungstechnischen Aufwand, die Fertigungszeit sowie -kosten. Darüber hinaus ist es vorteilhaft, wenn eine Längsachse des ersten Kanalabschnittes des Ausgleichskanales, welcher durch die wenigstens eine, zumindest teilweise in der Abschirmungsstruktur ausgeformte Ausnehmung ausgebildet ist, normal zu der Oberfläche der Komponente gerichtet ist. Einerseits wäre dadurch eine simple Fertigung im Sinne einer einfachen Entformbarkeit, beispielsweise der Komponente, im Anschluss an einen Gießprozess und andererseits eine gesteigerte Abschirmwirkung gegen das Eindringen von Partikeln oder Flüssigkeit in den Ausgleichskanal gegeben.

Ist darüber hinaus ein zweiter Kanalabschnitt des Ausgleichskanales durch wenigstens eine Ausnehmung oder Durchbrechung in der Abschirmungsstruktur ausgebildet und/oder ist eine Längsachse des durch die wenigstens eine Ausnehmung oder Durchbrechung in der Abschirmungsstruktur ausgebildeten zweiten Kanalabschnittes des Ausgleichskanales parallel zu der Oberfläche der Komponente gerichtet, so ist es in einfacher Weise möglich, den zweiten Kanalabschnitt mittels lediglich eines Fertigungsprozesses, beispielsweise durch Bohren oder Fräsen zu erzeugen. Denkbar ist in diesem Zusammenhang, dass der zweite Kanalabschnitt eine als eine Durchgangsbohrung oder ein Sackloch ausgeführt ist.

Für die Herstellung der Komponente der Vorrichtung wären somit lediglich zwei Fertigungsprozesse notwendig, hierbei ein Gießprozess zur Herstellung der Komponente mit Abschirmungsstruktur, Sitz sowie erstem Kanalabschnitt und ein zweiter Fertigungsprozess zur Erzeugung des zweiten Kanalabschnittes.

Der erste Kanalabschnitt und der zweite Kanalabschnitt bilden den Ausgleichskanal, wodurch diese bedingterweise miteinander verbunden sind. Die Kanalabschnitte können dabei T-förmig oder auch L-förmig zueinander angeordnet sein, sodass in T-förmiger Ausgestaltung z. B. ein Ende des ersten Kanalabschnittes mittig der Längserstreckung des zweiten Kanalabschnittes mit diesem verbunden ist respektive in diesen mündet. In L-förmiger Ausführung würde jeweils ein Ende des ersten Kanalabschnittes mit einem Ende des zweiten Kanalabschnittes verbunden sein bzw. diese ineinander münden.

In diesem Zusammenhang ließe sich zudem ein Verhältnis des Durchmessers des ersten Kanalabschnittes zu dem Durchmesser des zweiten Kanalabschnittes definieren, welches in einem Bereich von 2:1 bis 1:2 liegen und/oder das Verhältnis des Durchmessers des ersten Kanalabschnittes zu dem Durchmesser des zweiten Kanalabschnittes 1,25:1 betragen sollte.

Als äußerst praxisgerecht ist die Erfindung anzusehen, wenn die Vorrichtung eine Pumpe und/oder die Komponente der Vorrichtung ein Deckel ist. Hierbei könnte unterhalb des Deckels eine Elektronik angeordnet sein, wobei zur Minimierung oder gar der Verhinderung der Korrosion der Elektronik ein Druckausgleich notwendig wäre.

Die zweite Aufgabe wird gelöst durch ein Verfahren zur Herstellung der Komponente der Vorrichtung gemäß den Merkmalen des Patentanspruches 8. Die Unteransprüche betreffen besonders zweckmäßige Weiterbildungen der Erfindung.

Weiterhin ist somit erfindungsgemäß ein Verfahren zur Herstellung der Komponente der Vorrichtung vorgesehen, bei welchem ein erster Fertigungsschritt der Komponente die Erzeugung des ersten Kanalabschnittes in der Abschirmstruktur der Komponente innerhalb eines Gießprozesses in einer Gussform beinhaltet. In einem sich dem ersten Fertigungsschritt anschließenden, weiteren Fertigungsschritt erfolgt dann die Erzeugung des zweiten Kanalabschnittes mittels eines Bohr- oder Fräsprozesses. Im ersten Fertigungsschritt, dem Gießprozess, wird somit die Komponente mit wesentlichen Elementen der Komponente erzeugt. Neben dem ersten Kanalabschnitt sollte zudem die Abschirmstruktur sowie der Sitz im ersten Fertigungsschritt erzeugt werden. In dem weiteren, sich anschließenden Fertigungsschritt wäre es dann lediglich notwendig, den zweiten Kanalabschnitt durch Bohren oder auch Fräsen in der Abschirmstruktur zu erzeugen. Dies ermöglicht eine überaus kostengünstige Fertigung der Komponente mit einer möglichst geringen Anzahl an Fertigungsschritten.

Wird hierbei zur Erzeugung der Kontaktfläche des Sitzes der Komponente in dem ersten Fertigungsschritt ein Einleger in die Gussform eingebracht oder in einem sich dem ersten Fertigungsschritt anschließenden, weiteren Fertigungsschritt durch mechanischen Druck eines Stempels auf den im ersten Fertigungsschritt vorgegossenen Sitz der Sitz nachbearbeitet, dann ist dies dahingehend mit als Vorteil behaftet anzusehen, dass dadurch eine höhere Oberflächengüte, insbesondere eine geringere gemittelte Rautiefe der Kontaktfläche des Sitzes gegenüber weiteren Oberflächen der Komponente geschaffen werden kann. Hierfür ist es notwendig, dass der Einleger oder der Stempel gegenüber der Gussform sowie gegenüber der zu erzeugenden Komponente eine höhere Oberflächengüte aufweist. Durch eine hohe Oberflächengüte des Sitzes ließe sich beispielsweise eine Klebeverbindung zwischen dem insbesondere als Membran ausgebildeten Druckausgleichselement und der Kontaktfläche des Sitzes realisieren, welche eine verbesserte Haftung sowie eine höhere Dichtheit aufweist.

Die Erfindung ist darüberhinausgehend als gewinnbringend gekennzeichnet, wenn der Einleger oder der Stempel nach Überschreiten eines Abnutzungskriteriums ausgetauscht wird und/oder das Abnutzungskriterium durch eine gemittelte Rautiefe der Kontaktfläche des Sitzes kleiner oder gleich 16 Mikrometer bestimmt ist.

Die Erfindung lässt zahlreiche Ausführungsformen zu. Zur weiteren Verdeutlichung ihres Grundprinzips sind zwei davon in der Zeichnung dargestellt und werden nachfolgend beschrieben. Diese zeigt in
- Fig. 1: eine schematische Darstellung einer Weiterbildung der Vorrichtung;
- Fig. 2: eine Darstellung einer Weiterbildung der Vorrichtung als eine Pumpe.

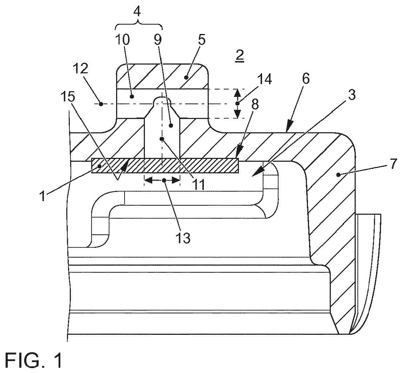

Figur 1 zeigt eine schematische Darstellung eines Teiles einer Weiterbildung der erfindungsgemäßen Vorrichtung. Die Vorrichtung weist hierbei das Druckausgleichselement 1 auf, wobei dieses Druckausgleichselement 1 zwischen den zwei Druckräumen 2, 3 angeordnet ist. Das Druckausgleichselement 1 ist in dieser Weiterbildung als eine PTFE-Membran ausgebildet und im Sitz 8 der Komponente 7 angeordnet, wobei das als PTFE-Membran ausgeführte Druckausgleichselement 1 mit der dem Druckausgleichselement 1 zugewandten Kontaktfläche 15 des Sitzes 8 verbunden ist. Diese Verbindung kann beispielsweise durch Kleben hergestellt sein. In jedem Fall ist es der Verbindung zuträglich, wenn die Kontaktfläche 15 eine gemittelte Rautiefe R_{z} kleiner oder gleich 16 Mikrometer aufweist. Überdies ist das Druckausgleichselement 1 gen des ersten Druckraumes 2 gerichtet, mit dem ersten Druckraum 2 über einen Ausgleichskanal 4 wirkverbunden, wobei der Ausgleichskanal 4 durch den ersten Kanalabschnitt 9 und den zweiten Kanalabschnitt 10 gebildet wird. Der erste Kanalabschnitt 9 sowie der zweite Kanalabschnitt 10 des Ausgleichskanales 4 sind dabei in der Abschirmungsstruktur 5 ausgebildet, wobei der erste Kanalabschnitt 9 durch eine Ausnehmung und der zweite Kanalabschnitt durch eine Durchbrechung ausgeformt sind, welche miteinander eine T-förmige Struktur aufweisen. Der Durchmesser 13 des ersten Kanalabschnittes 9 beträgt in dieser Weiterbildung 2,5 Millimeter, der Durchmesser 14 des zweiten Kanalabschnittes 10 2 Millimeter. Die Abschirmungsstruktur 5 ist zudem von der eine Grenzfläche mit dem ersten Druckraum 2 bildenden Oberfläche 6 in Richtung des ersten Druckraumes 2 in der Komponente 7 der Vorrichtung ausgeformt, wobei die Oberfläche 6 Teil der Mantelfläche der den zweiten Druckraum 3 teilweise gegenüber dem ersten Druckraum 2 abgrenzenden Komponente 7 ist. Weiterhin ist in Figur 1 dargestellt, dass die Längsachse 11 des ersten Kanalabschnittes 9 normal zu der Oberfläche 6 der Komponente 7 und die Längsachse 12 des zweiten Kanalabschnittes 10 des Ausgleichskanales 4 parallel zu der Oberfläche 6 der Komponente 7 gerichtet ist.

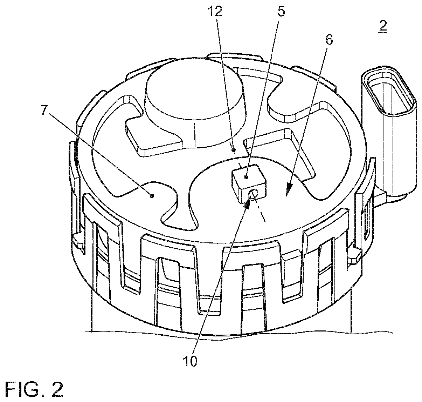

In Figur 2 ist ein Teil einer Weiterbildung der erfindungsgemäßen Vorrichtung dargestellt, in welcher die Vorrichtung als eine Pumpe und die Komponente 7 der Vorrichtung als ein Deckel ausgebildet ist. Die Abschirmungsstruktur 5 ist dabei in dem Deckel und im Wesentlichen als eine Quaderstruktur mit abgerundeten Kanten ausgeformt, wobei der Deckel den als Inneres der Pumpe ausgebildeten und in Figur 1 dargestellten zweiten Druckraum 3 teilweise gegenüber dem ersten Druckraum 2, hier der Umgebung, abgrenzt. Die Abschirmungsstruktur 5 ist wiederum von der eine Grenzfläche mit dem ersten Druckraum 2 bildenden Oberfläche 6 in Richtung der Umgebung in dem Deckel der Pumpe ausgeformt, wobei die Längsachse 12 des zweiten Kanalabschnittes 10 wiederum parallel zu der Oberfläche 6 des Deckels gerichtet ist. Durch die Abschirmungsstruktur 5 ist das in Figur 1 dargestellte und als PTFE-Membran ausgebildete Druckausgleichselement 1, welches zudem auf der der Abschirmungsstruktur 5 entgegengesetzten Seite des Deckels angeordnet ist, gegenüber äußeren mechanischen Einwirkungen, wie einem Hochdruckwasserstrahl oder Hochdruckdampfstrahl, die beispielsweise bei einem IPX9K-Test auf die Pumpe respektive den Deckel und die Abschirmungsstruktur 5 wirken, geschützt. Zugleich ist ein Druckausgleich zwischen dem Inneren der Pumpe und der Umgebung möglich, wodurch die Bildung von Kondenswasser und somit eine mögliche Korrosion einer unterhalb des Deckels liegenden Elektronik der Pumpe minimiert oder gar verhindert wird.

### Bezugszeichenliste

- 1: Druckausgleichselement
- 2: Erster Druckraum
- 3: Zweiter Druckraum
- 4: Ausgleichskanal
- 5: Abschirmungsstruktur

- 6: Oberfläche
- 7: Komponente
- 8: Sitz
- 9: Erster Kanalabschnitt
- 10: Zweiter Kanalabschnitt

- 11: Längsachse
- 12: Längsachse
- 13: Durchmesser
- 14: Durchmesser
- 15: Kontaktfläche

## Patentansprüche

1. Vorrichtung mit einem Druckausgleichselement (1), wobei das Druckausgleichselement (1) zwischen zwei Druckräumen (2, 3) einen Druckausgleich ermöglichend angeordnet und hierbei das Druckausgleichselement (1) zumindest in Richtung eines ersten Druckraumes (2) der Druckräume (2, 3) gerichtet mit diesem ersten Druckraum (2) über einen Ausgleichskanal (4) wirkverbunden ist, wobei der Ausgleichskanal (4) zumindest teilweise in einer Abschirmungsstruktur (5) ausgebildet und diese Abschirmungsstruktur (5) von einer eine Grenzfläche mit dem ersten Druckraum (2) bildenden Oberfläche (6) der Vorrichtung in Richtung des ersten Druckraumes (2) ausgeformt ist, und durch einen ersten Kanalabschnitt (9), wobei die Längsachse (11) des ersten Kanalabschnittes (9) normal zur Oberfläche (6) der Vorrichtung ausgerichtet ist, und einen zweiten Kanalabschnitt (10), wobei die Längsachse (12) des zweiten Kanalabschnittes (10) parallel zur Oberfläche (6) der Vorrichtung ausgerichtet ist, ausgebildet ist, **dadurch gekennzeichnet, dass** der Durchmesser (13) des ersten Kanalabschnittes (9) in einem Bereich von 2 Millimeter bis 3 Millimeter und der Durchmesser (14) des zweiten Kanalabschnittes (10) in einem Bereich von 1,5 Millimeter bis 2,5 Millimeter liegen.

2. Vorrichtung nach Anspruch 1, **dadurch gekennzeichnet, dass** die Oberfläche (6) Teil einer Mantelfläche einer den zweiten Druckraum (3) zumindest teilweise gegenüber dem ersten Druckraum (2) abgrenzenden Komponente (7) der Vorrichtung ist.

3. Vorrichtung nach den Ansprüchen 1 oder 2, **dadurch gekennzeichnet, dass** in der Komponente (7) ein Sitz (8) für das Druckausgleichselement (1) ausgeformt ist und/oder der in der Komponente (7) ausgeformte Sitz (8) für das Druckausgleichselement (1) eine dem Druckausgleichselement (1) zugewandte Kontaktfläche (15) aufweist, deren gemittelte Rautiefe kleiner oder gleich 16 Mikrometer beträgt.

4. Vorrichtung nach zumindest einem der vorangehenden Ansprüche, **dadurch gekennzeichnet, dass** der erste Kanalabschnitt (9) des Ausgleichskanales (4) durch wenigstens eine zumindest teilweise in der Abschirmungsstruktur (5) ausgeformte Ausnehmung ausgebildet ist.

5. Vorrichtung nach zumindest einem der vorangehenden Ansprüche, **dadurch gekennzeichnet, dass** der zweite Kanalabschnitt (10) des Ausgleichskanales (4) durch wenigstens eine Ausnehmung oder Durchbrechung in der Abschirmungsstruktur (5) ausgebildet ist.

6. Vorrichtung nach zumindest einem der vorangehenden Ansprüche, **dadurch gekennzeichnet, dass** der Durchmesser (13) des ersten Kanalabschnittes (9) 2,5 Millimeter und der Durchmesser (14) des zweiten Kanalabschnittes (10) 2 Millimeter beträgt.

7. Vorrichtung nach zumindest einem der vorangehenden Ansprüche, **dadurch gekennzeichnet, dass** die Vorrichtung eine Pumpe und/oder die Komponente (7) der Vorrichtung ein Deckel ist.

8. Verfahren zur Herstellung der Komponente (7) der Vorrichtung nach zumindest einem der vorangehenden Ansprüche, **dadurch gekennzeichnet, dass** ein erster Fertigungsschritt der Komponente (7) die Erzeugung des ersten Kanalabschnittes (9) in der Abschirmstruktur (5) der Komponente (7) innerhalb eines Gießprozesses in einer Gussform beinhaltet, wobei in einem sich dem ersten Fertigungsschritt anschließenden weiteren Fertigungsschritt die Erzeugung des zweiten Kanalabschnittes (10) mittels eines Bohr- oder Fräsprozesses erfolgt.

9. Verfahren nach Anspruch 8, **dadurch gekennzeichnet, dass** zur Erzeugung der Kontaktfläche (15) des Sitzes (8) der Komponente (7) in dem ersten Fertigungsschritt ein Einleger in die Gussform eingebracht wird oder in einem sich dem ersten Fertigungsschritt anschließenden, weiteren Fertigungsschritt durch mechanischen Druck eines Stempels auf den im ersten Fertigungsschritt vorgegossenen Sitz (8) der Sitz (8) nachbearbeitet wird.

10. Verfahren nach den Ansprüchen 8 oder 9, **dadurch gekennzeichnet, dass** der Einleger oder der Stempel nach Überschreiten eines Abnutzungskriteriums ausgetauscht wird und/oder das Abnutzungskriterium durch eine gemittelte Rautiefe der Kontaktfläche (15) des Sitzes (8) kleiner oder gleich 16 Mikrometer bestimmt ist.

## Claims

1. Device having a pressure equalizing element (1), wherein the pressure equalizing element (1) is arranged between two pressure chambers (2, 3) allowing a pressure equalization, and the pressure equalizing element (1) is hereby operatively connected, at least in the direction of a first pressure chamber (2) of the pressure chambers (2, 3), to this first pressure chamber (2) via an equalizing channel (4), wherein the equalizing channel (4) is formed at least partially in a shielding structure (5), and this shielding structure (5) is formed by a surface (6) of the device in the direction of the first pressure chamber (2), said surface (6) forming an interface with the first pressure chamber (2), and by a first channel segment (9), wherein the longitudinal axis (11) of the first channel segment (9) is oriented normal to the surface (6) of the device; and a second channel segment (10), wherein the longitudinal axis (12) of the second channel segment (10) is oriented parallel to the surface (6) of the device; **characterized in that** the diameter (13) of the first channel segment (9) lies in a range of 2 millimeters to 3 millimeters, and the diameter (14) of the second channel segment (10) lies in a range of 1.5 millimeters to 2.5 millimeters.

2. Device according to Claim 1, **characterized in that** the surface (6) is part of a shell surface of a component (7) of the device, said component (7) bordering the second pressure chamber (3) at least partially opposite the first pressure chamber (2).

3. Device according to Claims 1 or 2, **characterized in that** a seat (8) for the pressure equalizing element (1) is molded in the component (7), and/or the seat (8) for the pressure equalizing element (1), said seat (8) being molded in the component (7), has a contact surface (15), facing toward the pressure equalizing element (1), whose mean roughness depth is less than or equal to 16 micrometers.

4. Device according to at least one of the preceding claims, **characterized in that** the first channel segment (9) of the equalizing channel (4) is formed by at least one recess molded at least partially in the shielding structure (5).

5. Device according to at least one of the preceding claims, **characterized in that** the second channel segment (10) of the equalizing channel (4) is formed by at least one recess or through-hole in the shielding structure (5).

6. Device according to at least one of the preceding claims, **characterized in that** the diameter (13) of the first channel segment (9) is 2.5 millimeters, and the diameter (14) of the second channel segment (10) is 2 millimeters.

7. Device according to at least one of the preceding claims, **characterized in that** the device is a pump and/or the component (7) of the device is a lid.

8. Method for producing the component (7) of the device according to at least one of the preceding claims, **characterized in that** a first manufacturing step of the component (7) includes the production of the first channel segment (9) in the shielding structure (5) of the component (7) in a casting mold within a casting process, wherein the production of the second channel segment (10) takes place by means of a drilling or milling process in a further manufacturing step following the first manufacturing step.

9. Method according to Claim 8, **characterized in that,** in order to produce the contact surface (15) of the seat (8) of the component (7), an insert is introduced into the casting mold in the first manufacturing step or, in a further manufacturing step following the first manufacturing step, the seat (8) is reworked by mechanical pressure of a stamp on the seat (8) cast in the first manufacturing step.

10. Method according to Claims 8 or 9, **characterized in that** the insert or the stamp is replaced after a wear criterion is exceeded, and/or the wear criterion is determined by a mean roughness depth of the contact surface (15) of the seat (8) of less than or equal to 16 micrometers.

## Revendications

1. Dispositif doté d'un élément de compensation de pression (1), dans lequel l'élément de compensation de pression (1) est disposé entre deux chambres de pression (2, 3) pour permettre une compensation de pression et ainsi l'élément de compensation de pression (1), orienté au moins en direction d'une première chambre de pression (2) des chambres de pression (2, 3), est en liaison active avec cette première chambre de pression (2) par le biais d'un canal de compensation (4), dans lequel le canal de compensation (4) est formé au moins partiellement en une structure de blindage (5) et cette structure de blindage (5) est façonnée par une surface (6) formant une surface limite avec la première chambre de pression (2) du dispositif en direction de la première chambre de pression (2) et est conçu par une première section de canal (9), dans lequel l'axe longitudinal (11) de la première section de canal (9) est orientée perpendiculaire à la surface (6) du dispositif et une seconde section de canal (10), dans lequel l'axe longitudinal (12) de la seconde section de canal (10) est orientée parallèle à la surface (6) du dispositif **caractérisé en ce que** le diamètre (13) de la première section de canal (9) se situe dans une plage de 2 millimètres à 3 millimètres et le diamètre (14) de la seconde section de canal (10) dans une plage de 1,5 millimètre à 2,5 millimètres.

2. Dispositif selon la revendication 1, **caractérisé en ce que** la surface (6) forme une partie d'une surface d'enveloppe d'un composant (7) du dispositif délimitant la seconde chambre de pression (3) au moins partiellement par rapport à la première chambre de pression (2).

3. Dispositif selon les revendications 1 ou 2, **caractérisé en ce que** dans le composant (7), un siège (8) pour l'élément de compensation de pression (1) est formé et/ou le siège (8) formé dans le composant (7) présente pour l'élément de compensation de pression (1) une surface de contact (15) orientée vers l'élément de compensation de pression (1), dont la rugosité de surface moyenne est inférieure ou égale à 16 micromètres.

4. Dispositif selon au moins une quelconque des revendications précédentes, **caractérisé en ce que** la première section de canal (9) du canal de compensation (4) est conçue par au moins une cavité formée au moins partiellement dans la structure de blindage (5).

5. Dispositif selon au moins une quelconque des revendications précédentes, **caractérisé en ce que** la seconde section de canal (10) du canal de compensation (4) est conçue par au moins une cavité ou découpe dans la structure de blindage (5).

6. Dispositif selon au moins une quelconque des revendications précédentes, **caractérisé en ce que** le diamètre (13) de la première section de canal (9) est de 2,5 millimètres et le diamètre (14) de la seconde section de canal (10) est de 2 millimètres.

7. Dispositif selon au moins une quelconque des revendications précédentes, **caractérisé en ce que** le dispositif est une pompe et/ou le composant (7) du dispositif est un couvercle.

8. Procédé de confection d'un composant (7) du dispositif selon au moins une quelconque des revendications précédentes, **caractérisé en ce qu'une** première étape de fabrication du composant (7) inclut la production de la première section de canal (9) dans la structure de blindage (5) du composant (7) au cours d'un processus de moulage dans un moule, dans lequel dans une autre étape de fabrication suivant la première étape de fabrication, la production de la seconde section de canal (10) est réalisée au moyen d'un processus de forage ou de fraisage.

9. Procédé selon la revendication 8, **caractérisé en ce que,** pour la production de la surface de contact (15) du siège (8) du composant (7) dans la première étape de fabrication, un insert est appliqué dans le moule ou dans une autre étape de fabrication suivant la première étape de fabrication, le siège (8) est retravaillé par pression mécanique d'un poinçon sur le siège (8) pré-moulé dans la première étape de fabrication.

10. Procédé selon les revendications 8 ou 9, **caractérisé en ce que** l'insert ou le poinçon est échangé après avoir dépassé un critère d'usure et/ou le critère d'usure est déterminé par une rugosité de surface moyenne de la surface de contact (15) du siège (8) inférieure ou égale à 16 micromètres.
